# EUROPEAN PATENT APPLICATION

(11) **EP 1 791 407 A1**
(43) Date of publication of application: **30.05.2007**
(21) Application number: 06255975.2
(22) Date of filing: 22.11.2006
(51) Int. Cl.: H05K 3/36, G01R 31/00

(54) **Method for manufacturing multilayer printed circuit board with through hole**

(30) Priority: 24.11.2005 JP 2005339441
(71) Applicant: ORION ELECTRIC CO., Ltd., Fukui 915-8555 (JP)
(72) Inventor: Ishida, Keishiro, c/o IPD, Echizen-city Fukui 915-8555 (JP); Kuwashima, Kiichiro, c/o IPD, Echizen-city Fukui 915-8555 (JP)
(74) Representative: Paget, Hugh Charles Edward

(57) **Abstract**

The invention provides a multi-layer printed circuit board with a through hole having a connection formed by filling conductive paste in the through hole, wherein the voltage of a circuit having constant current flow is stabilized. The circuit board comprises a closed circuit that starts from a power supply terminal and passes a power supply line 17, a connection connecting the patterns on the front and rear surfaces of the board, a load and a ground line 18 to reach an earth terminal, wherein if the voltage drop at the connection exceeds a value determined based on a predetermined rate with respect to the power supply voltage, all or some of the connections is replaced with a jumper wire 19 so that the voltage drop at the connection is equal to or smaller than a value determined by said predetermined rate, according to which the voltage level of the power supply line 17 and the ground line 18 is stabilized.

## Description

### BACKGROUND OF THE INVENTION

### Field of the Invention

The present invention relates to a multi-layer printed circuit board having circuits formed on multiple layers, and more specifically, relates to a multi-layer printed circuit board in which the electrical connection between two layers is realized by a connection formed by filling conductive paste in a through hole (such as a silver through hole).

### Description of the Related Art

Conventionally, a multi-layer printed circuit board having circuits formed on multiple layers is used to enhance the mounting density of circuits, wherein the electrical connection between two layers (a front surface and a rear surface of the board) is realized by a connection formed by filling conductive paste in a through hole (such as a silver through hole). Japanese Patent Application Laid-Open Publications No. 8-148796 and No. 2002-164632 (Patent documents 1 and 2) disclose such prior art techniques related to a printed circuit board having connections formed by filling conductive paste in through holes.

Furthermore, Japanese Patent Application Laid-Open Publications No. 4-139889, No. 11-251733 and No. 2000-208892 (patent documents 3 through 5) disclose prior art techniques related to printed circuit boards having jumper wires, in which the electrical connection between two layers of a printed circuit board is realized by a conductive member (jumper wire) inserted to a through hole and fixed via soldering.

Silver through holes are used widely due to their low manufacturing costs, but since the silver through holes have limited allowable current and resistance (the value of which is dispersed by manufacture accuracy and variation with time), there is a drawback in that if the silver through holes are used in a circuit with a relatively high current flow, voltage drop may occur at the silver through holes so that it may be impossible to obtain necessary voltage at the required locations in the circuit (or the voltage value may become instable). It is possible to consider a method to overcome this problem by reducing the resistance of the "silver through hole connection" by connecting the circuits via multiple silver through holes (according to which multiple silver through holes are connected in parallel in the circuits), however, the dispersion of manufacture accuracy of the silver through holes may cause insufficient reduction of resistance of the "silver through hole connection" (for example, if two silver through holes are formed, it is expected that the resistance of each will be reduced to one-half, but when one of the silver through holes is defective, the resistance will not be reduced to one-half), and further, the forming of multiple silver through holes causes the increase of required board area, which leads to deterioration of board efficiency.

### SUMMARY OF THE INVENTION

The present invention aims at solving the above-mentioned problems by providing a multi-layer printed circuit board with a through hole having connections formed by filling conductive paste in through holes, thereby stabilizing the voltage of a circuit having a constant amount of current flow.

The multi-layer printed circuit board with a through hole according to aspect 1 comprises circuits formed at least on a front surface and a rear surface of the board, a power supply terminal to which a power supply voltage is entered, an earth terminal connected to a ground level functioning as a reference voltage, a power supply line connected to the power supply terminal, a ground line connected to the earth terminal, a connection for electrically connecting circuits formed on the front surface and the rear surface of the board by providing a through hole and filling the interior thereof with conductive paste, and a load connected to the power supply line and the ground line to receive power supply, the multi-layer printed circuit board having the power supply line and the ground line formed on the front surface and the rear surface thereof respectively according to the required circuit configuration, with the power supply line or the ground line formed on the front surface and the power supply line or the ground line formed on the rear surface electrically connected via said connection; characterized in that with respect to a closed circuit that starts from the power supply terminal and passes the power supply line, one or more of said connections, the load and the ground line to reach the earth terminal, if a voltage drop quantity of said one or more connections exceeds a value determined by a predetermined rate with respect to the power supply voltage, all or some of said one or more connections are replaced with a jumper wire so that the voltage drop quantity at said one or more connections is equal to or smaller than the value determined by the predetermined rate.

According to the above arrangement, in a closed circuit that starts from the power supply terminal and passes the power supply line, one or more of said connections, the load and the ground line to reach the earth terminal, the voltage drop occurring at the connections (connections electrically connecting circuits formed on a front surface of a board and the rear surface thereof by disposing through holes and filling conductive paste therein) is equal to or smaller than a value determined by the predetermined rate with respect to the power supply voltage. In addition, "replaced with a jumper wire" not only means that a jumper wire is used in replacement of a connection formed by filling conductive paste in a through hole, but also includes inserting a jumper wire in a through hole and filling the hole with conductive paste (wherein both methods are used simultaneously).

The multi-layer printed circuit board with a through hole according to aspect 2 provides a multi-layer printed circuit board according to aspect 1, wherein the conductive paste is a silver paste, according to which the connection is a silver through hole, and the predetermined rate is 2 %.

According to the above arrangement, with respect to a closed circuit that starts from the power supply terminal and passes the power supply line, one or more silver through holes (or jumper wires), the load and the ground line to reach the earth terminal, the voltage drop occurring at the connection (connection for electrically connecting the circuits formed on the front surface of the board and the rear surface thereof) is determined to be equal to or smaller than 2 % of the power supply voltage.

The multi-layer printed circuit board with a through hole according to aspect 3 characterizes in providing a multi-layer printed circuit board according to aspect 1 or aspect 2, wherein all of the connections formed on the ground line are replaced with the jumper wire.

According to the above arrangement, when ground lines are formed on the front surface of the board and the rear surface of the board, the electrical connection of the two layers are all realized via jumper wires.

The multi-layer printed circuit board with a through hole according to aspect 4 provides a multi-layer printed circuit board according to any one of aspects 1 through 3, wherein a portion of or all the jumper wires disposed on the ground line comprises a terminal portion to be inserted to the through hole, an intermediate bent portion, and a contact portion coming into contact with a chassis ground of an electronic device on which the multi-layer printed circuit board with a through hole and jumper wire is mounted.

According to the above arrangement, a contact portion coming into contract with a chassis ground of the electronic device is provided to a portion of or all the jumper wires.

The electronic device of aspect 5 provides an electronic device having the multi-layer printed circuit board with a through hole according to aspect 4, further comprising a conductive casing or a conductive frame, wherein the contact portion comes into contact with the casing or the frame.

According to the above arrangement, the "multi-layer printed circuit board with a through hole" is mounted on a device so that the contact portion of the jumper wire disposed on the ground line contacts a conductive casing or a conductive frame.

The method for manufacturing a multi-layer printed circuit board with a through hole according to aspect 6 comprises circuits formed at least on a front surface and a rear surface of the board, a power supply terminal to which a power supply voltage is entered, an earth terminal connected to a ground level functioning as a reference voltage, a power supply line connected to the power supply terminal, a ground line connected to the earth terminal, a connection for electrically connecting circuits formed on the front surface and the rear surface of the board by providing a through hole and filling the interior thereof with conductive paste, and a load connected to the power supply line and the ground line to receive power supply, the multi-layer printed circuit board having the power supply line and the ground line formed on the front surface and the rear surface thereof respectively according to the required circuit configuration, with the power supply line or the ground line formed on the front surface and the power supply line or the ground line formed on the rear surface electrically connected via said connection; the method characterized in that during a design stage, with respect to a closed circuit that starts from the power supply terminal and passes the power supply line, one or more of said connections, the load and the ground line to reach the earth terminal, if a voltage drop quantity of said one or more connections computed based on a current value determined by the power supply specification of the circuit exceeds a value determined by a predetermined rate with respect to the power supply voltage, all or some of said one or more connections are replaced with a jumper wire so that the voltage drop quantity at said one or more connections is equal to or smaller than the value determined by the predetermined rate; or during an experimental stage, with respect to a closed circuit that starts from the power supply terminal and passes the power supply line, one or more of said connections, the load and the ground line to reach the earth terminal, if a voltage drop quantity of said one or more connections computed based on a measured current value or a voltage drop quantity obtained by measuring a voltage value between terminals of said one or more connections exceeds a value determined by a predetermined rate with respect to the power supply voltage, all or some of said one or more connections are replaced with a jumper wire so that the voltage drop quantity at said one or more connections is equal to or smaller than the value determined by the predetermined rate.

The method for manufacturing a multi-layer printed circuit board with a through hole provides the method for manufacturing a multi-layer printed circuit board according to claim 6, wherein the conductive paste is a silver paste, according to which said connection is a silver through hole, and the predetermined rate is 2 %.

According to the first aspect of the present invention, the voltage drop occurring at the connections (connections for electrically connecting circuits formed on the front surface of the board and the rear surface thereof) are set equal to or smaller than the value determined by the predetermined rate with respect to the power supply voltage, so that it becomes possible to obtain necessary voltage at the necessary locations (loads) on the printed circuit board.

According to the second aspect of the present invention, the voltage drop occurring at the connections (connections for electrically connecting circuits formed on the front surface of the board and the rear surface thereof) is set equal to or smaller than 2 % of the power supply voltage, so that in a printed circuit board utilizing silver through holes manufactured at low cost, the voltage drop occurring at the connections is set equal to or smaller than 2 % of the power supply voltage, and therefore, the circuit board can be mounted on electronic devices that tend to malfunction if the supplied voltage errors more than 2 %.

According to the third aspect of the present invention, when ground lines are formed on the front surface of the board and the rear surface thereof, all the electrical connections between those layers are realized via jumper wires, so that the voltage level of the ground line (reference voltage level) is stabilized.

According to the fifth aspect of the present invention, the "multi-layer printed circuit board with a through hole" is mounted on the device so that the contact portion of the jumper wire disposed on the ground line comes into contact with the conductive casing or the conductive frame (so as to be grounded to the frame), and the voltage level of the ground line (reference voltage level) is further stabilized. Moreover, according to the above arrangement, it becomes possible to eliminate any special member for grounding the printed circuit board to the frame.

### BRIEF DESCRIPTION OF THE DRAWINGS

FIG. 1 is a perspective view showing the outline of a portion of the double-sided printed circuit board regarding the present invention;
FIG. 2 is a conceptual cross-sectional view illustrating a silver through hole portion;
FIG. 3 is a conceptual cross-sectional view showing a jumper wire portion;
FIG. 4 is a conceptual equivalent circuit that starts from the power supply terminal and passes the power supply line, the silver through hole, the load, the ground line to reach the earth terminal;
FIG. 5 shows another conceptual equivalent circuit;
FIG. 6 is a conceptual explanatory view comparing a portion in which silver through holes are used and a portion in which a jumper wire is used;
FIG. 7 is a conceptual cross-sectional view showing other jumper wire portions;
FIG. 8 is an exploded schematic view of an electronic device equipped with a multi-layer printed circuit board with a through hole according to the present invention; and
FIG. 9 is a schematic cross-sectional view taken along line A-A of FIG. 8.

### DETAILED DESCRIPTION OF THE PREFERRED EMBODIMENTS

Now, the actual preferred embodiments of the present invention will be described with reference to the drawings. The following embodiments are merely examples for carrying out the present invention, and they are not intended to limit the scope of the present invention.

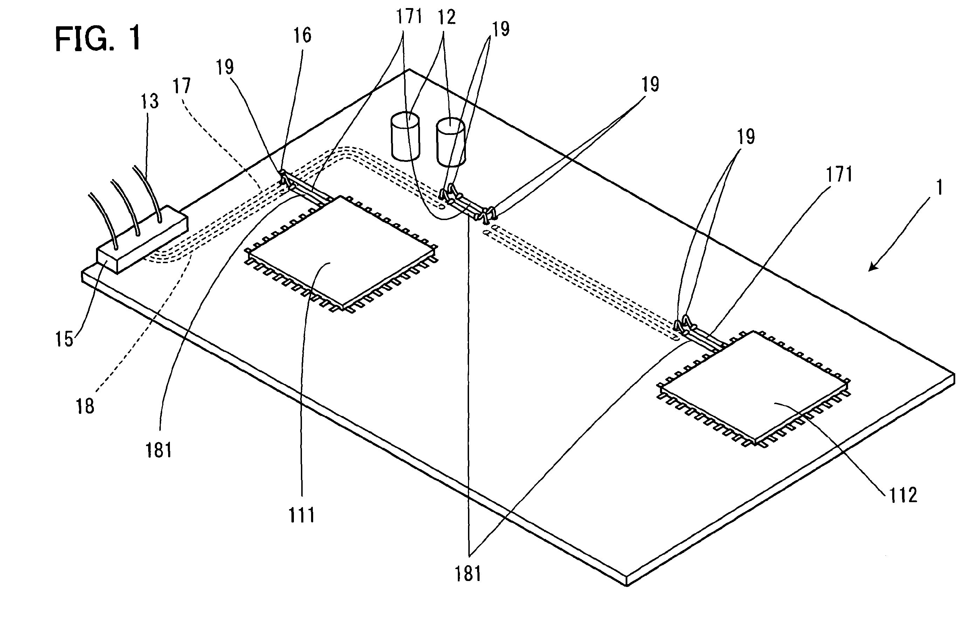

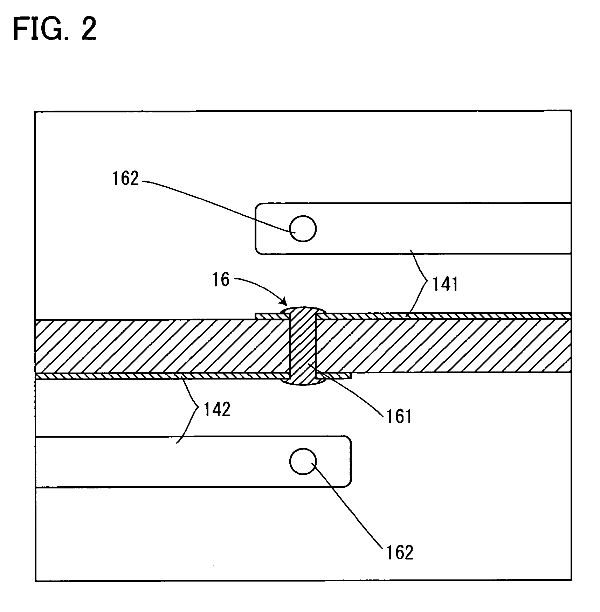

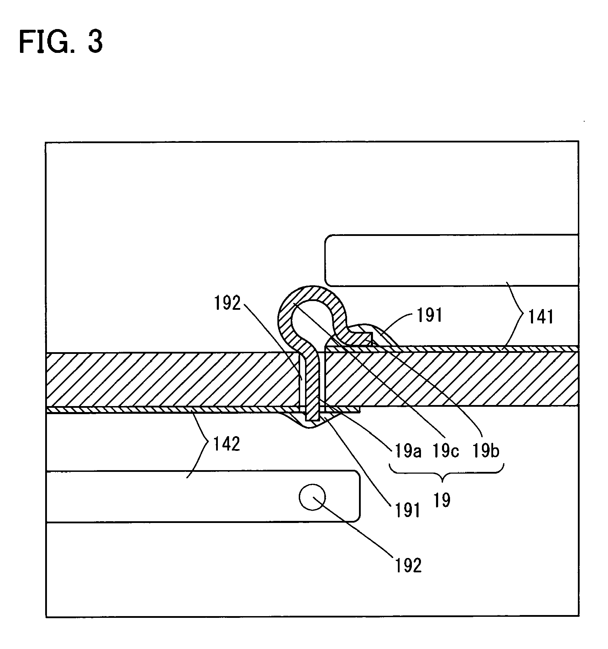

FIG. 1 is a perspective view showing the outline of a portion of a double-sided printed circuit board of the present embodiment according to the present invention, FIG. 2 is a conceptual cross-sectional view illustrating a silver through hole portion, and FIG. 3 is a conceptual cross-sectional view illustrating a jumper wire portion.

A double-sided printed circuit board 1 according to the present embodiment is a double-sided board having circuits formed on both the front side and the rear side thereof, wherein the electrical connection of electric/electronic components to the conductive pattern on the double-sided printed circuit board 1 is realized by dip soldering and reflow soldering. Though it is not shown in FIG. 1, various electric and electronic components (acting as "loads") are mounted on the double-sided printed circuit board 1, and on the front surface of the double-sided printed circuit board 1 (hereinafter referred to as the reflow surface) are mounted electronic devices 111 such as various ICs (surface mount members) connected electrically via reflow soldering to the conductive pattern on the printed circuit board 1 and lead wired components 12 connected electrically via dip soldering, and on the rear surface of the board (hereinafter referred to as the dip surface) are mounted chip components (not shown) connected electrically via dip soldering to the conductive pattern on the printed circuit board 1.

A connector 15 to which power wire members 13 for supplying power are connected is mounted on the double-sided printed circuit board 1, and on the connector are disposed a power supply terminal (not shown) to which power supply voltage is entered and an earth terminal (not shown) connected to a ground level which is the reference voltage.

The signal wire (not shown) for transmitting signals (small signals) between various ICs are mainly formed on the reflow surface, which is the surface on which the electronic devices such as various ICs are mounted, and the power supply line (conductive pattern connected to the power supply terminal) 17 for supplying power supply voltage to the components on the board and the ground line (conductive pattern connected with the earth terminal) 18 functioning as the reference potential are mainly formed on the dip surface. The expression "mainly formed on" the reflow surface or the dip surface refers to the surface on which the basic pattern is formed, and if the circuitry requires, the signal wire can also be formed on the dip surface and the power supply line 17 or the ground line 18 (the power supply line 171 or the ground line 181 in FIG. 1) can also be formed on the reflow surface.

The double-sided printed circuit board 1 according to the present embodiment realizes the electrical connection between the circuit (conductive pattern) on the reflow surface and the circuit on the dip surface via silver through holes. FIG. 2 is a schematic cross-sectional view showing the silver through hole portion. As shown in the drawing, the silver through hole 16 realizes the electrical connection between the conductive pattern 141 formed on the reflow surface and the conductive pattern 142 formed on the dip surface by forming a through hole 162 and filling the interior thereof with silver paste (conductive paste) 161.

The silver through hole 16 has a restricted allowable current and also has a resistance (the value of which is dispersed by manufacture accuracy and variation with time), so it has very little problem when it is used for a signal wire in which current basically does not flow (which has high impedance due to IC and the like) (in other words, voltage drop rarely occurs at the connection realized by the silver through hole 16), however, if the silver through hole 16 is used to connect the power supply line 17 and the ground line 18 through which certain amounts of currents flow, voltage drop will occur at the connection realized by the silver through hole 16, and necessary voltage may not be obtained at the necessary portions (IC 111 and IC 112) (in other words, the voltage value is not stabilized). In order to prevent this problem from occurring, according to the double-sided printed circuit board 1 of the present embodiment, when a certain condition is fulfilled, a jumper wire 19 is used instead of the silver through hole 16 to electrically connect the conductive pattern on the reflow surface and the conductive pattern on the dip surface.

FIG. 3 is a conceptual cross-sectional view showing a jumper wire portion. As shown in the drawing, the jumper wire 19 is inserted to a through hole 192, and comprises a terminal portion 19a soldered onto the conductive pattern 142 on the dip surface, a terminal portion 19b substantially perpendicular to the terminal portion and soldered onto the conductive pattern 141 on the reflow surface, and an intermediate bent portion 19c. The bent portion 19c functions as a thermal-expansion buffer preventing the soldering from being cracked, and also functions as a stopper for mounting the jumper wire 19 via an automated machine (which also exerts a similar effect when the wire is inserted manually).

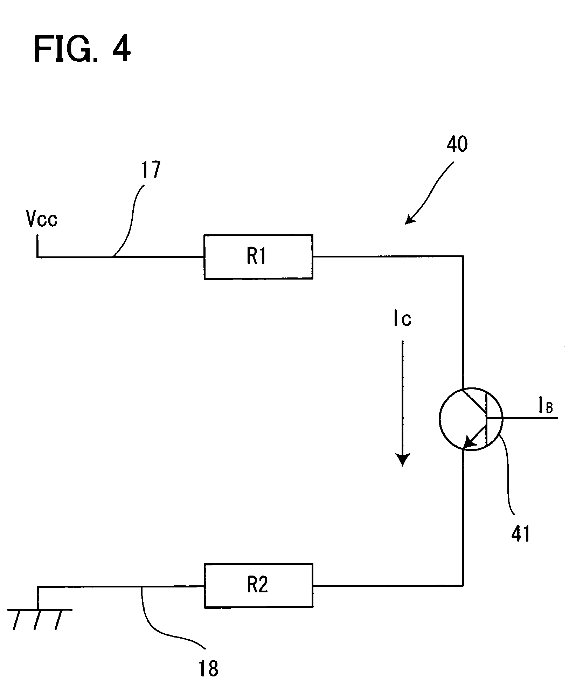

FIG. 4 shows a conceptual equivalent circuit of a closed circuit that starts from a power supply terminal (Vcc) and passes a power supply line 17, one or more silver through holes 16 and load (IC) and a ground line 18 to reach an earth terminal (GND). R1 represents resistance by the one or more silver through holes 16 formed on the power supply line 17, and similarly, R2 represents resistance by one or more silver through holes 16 formed on the ground line 18. The transistor 41 is a conceptual equivalent circuit of IC, which amplifies the small signal input to the base (or current input via the signal wire formed on the reflow surface) and outputs a corrector current Ic to the closed circuit 40. Accordingly, if the power supply voltage (Vcc) is 3.3 V and the allowable voltage error of the transistor 41 (IC) (which is the condition of error from the expected voltage that does not cause malfunction of the IC) is smaller than 2 %, then the voltage drop at R1 and R2 (silver through holes 16) must be smaller than 66 mV, so that when assuming that the small signal (base current) is 3 mA and the small signal current amplification factor of the transistor 41 (IC) is 100, it is necessary to set the resistance of R1 and R2 to be smaller than 0.22 Ω. Therefore, when assuming that the resistance of one silver through hole is 0.1 Ω (which is a general maximum resistance of a silver through hole considering the variation with time and the like, and usually, the resistance is 0.05 Ω or smaller), the number of silver through holes 16 capable of being connected in series is two at maximum.

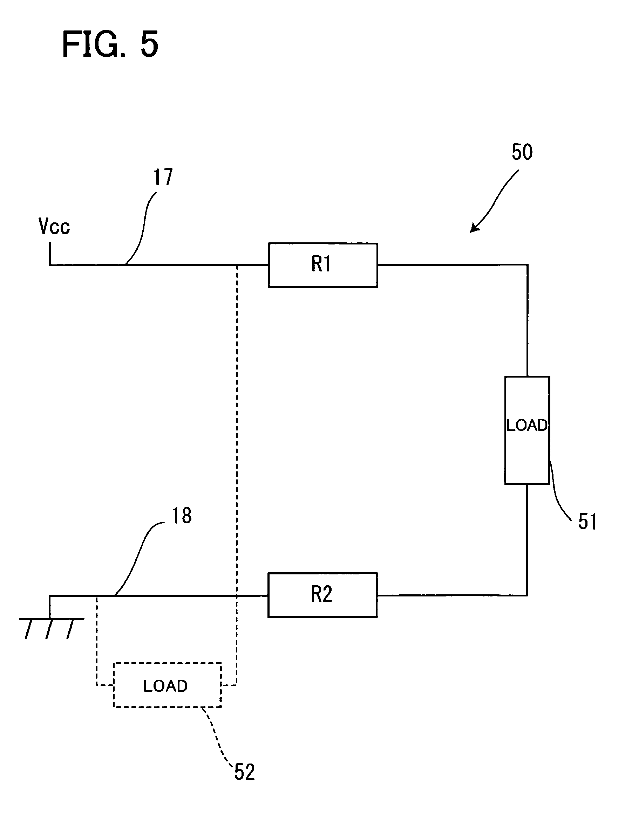

FIG. 5 shows another conceptual equivalent circuit 50. R1 and R2 respectively represent the resistance of the silver through hole 16 on the power supply line 17 and the ground line 18, and a load 51 is connected to the power supply line 17 and the ground line 18 to receive power supply. For example, if the power supply voltage (Vcc) is 3. 3 V and the allowable voltage error of the load 51 is smaller than 1.5 %, the voltage drop at R1 and R2 (silver through holes 16) must be smaller than 49.5 mV, and if the resistance of the load 51 is 2 Ω, the resistance of R1 and R2 must be set smaller than approximately 0.35 Ω. Therefore, if the resistance of one silver through hole is 0.1 Ω (which is the general maximum resistance of a silver through hole), the number of silver through holes 16 capable of being connected in series is three at maximum. It is basically not possible to take measures to set the power supply voltage higher to correspond to the quantity of voltage drop at R1 and R2. By taking such measures, it will not be possible to satisfy the allowable voltage error of the load 52 connected without intervening R1 and R2, as shown by the dotted line of FIG. 5.

During the design stage of the double-sided printed circuit board 1, after determining the size of the board, the components to be used and the number thereof, after creating the circuit diagram and determining the power supply specification, and while determining the layout of the board pattern (during which stage the number of connections between the reflow surface and the dip surface, that is, the number of locations where silver through holes are to be used, is determined), the number of silver through holes capable of being used according to the specification of the circuit is computed as described in the earlier example, and jumper wires 19 are used instead of some of the silver through holes 16 in order to satisfy the above-mentioned conditions. In addition, since the actual board may not operate according to the theoretical value (expected value) computed during the design stage due to various causes (such as the energy released as heat and electromagnetic waves unconsidered during the design stage), it is necessary to actually measure the current etc. of each circuit when a prototype is created, so that when a portion not satisfying the conditions is discovered, the design can be reconsidered, for example, to satisfy the conditions by using a jumper wire 19 instead of the silver through hole 16 in some areas. The double-sided printed circuit board 1 is formed after such designing and manufacture stages. According to the double-sided printed circuit board 1 shown conceptually in FIG. 1, a silver through hole 16 is used to connect the power supply line 17 (conductive pattern on the dip surface) on the power supply line to the IC 111 with the power supply line 171 (conductive pattern on the reflow surface), but all the other connections on the power supply line 17 and the ground line 18 are realized via jumper wires 19. (In addition, the connection of signal wires is performed via silver through holes).

As described, according to the double-sided printed circuit board 1 of the present embodiment, the voltage drop occurring at the connections (the connected areas of the reflow surface and the dip surface) is set either equal to or smaller than the value determined by the predetermined rate to the power supply voltage, so that the necessary voltage (stabilized voltage) can be obtained at the necessary areas (loads) on the printed circuit board. Furthermore, by setting the "predetermined rate" to 2 % of the power supply voltage, it becomes possible to provide a printed circuit board that can be manufactured at low cost by utilizing silver through holes wherein the voltage drop occurring at the silver through hole portions is set to 2 % or smaller (or smaller than 2 %) of the power supply voltage, satisfying the general allowable voltage error (which is the condition of error from the expected voltage that does not cause malfunction of the IC). In addition, considering various causes (considering the safety margin), it is preferable that the "predetermined rate" is set to 1.5 % or smaller of the power supply voltage.

Furthermore, since a jumper wire 19 is disposed on the power supply line 17 and the ground line 18, it becomes possible to use the jumper wire as test pin, realizing superior workability during maintenance and the like. In other words, there are cases in which the voltage value or the waveform must be measured during reconsideration of the design of the device (such as when evaluating the prototype) or during maintenance, and conventionally in many cases, it is inevitable to utilize the pins of ICs, however, if the pitch between the pins is small (the pitch is reduced year by year), the workability thereof is deteriorated and the device is susceptible to damage, but according to the double-sided printed circuit board 1 of the present embodiment, the jumper wire 19 can be utilized as the test pin, according to which the operability during maintenance and the like is improved.

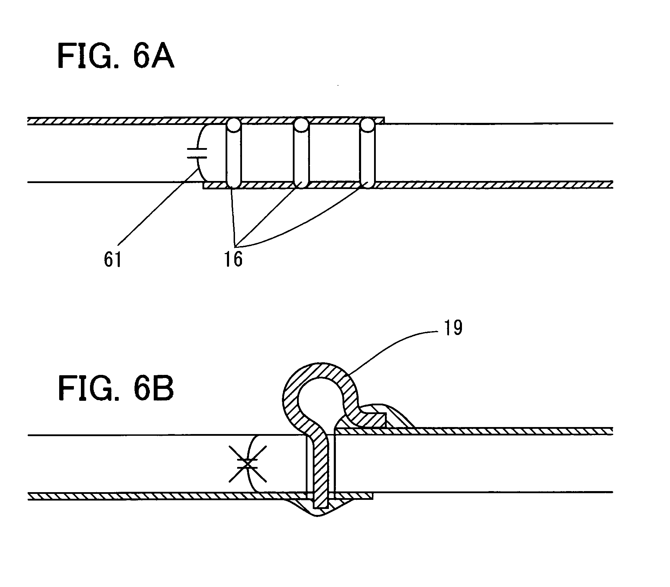

Furthermore, as shown in the conceptual explanatory view of FIG. 6(a), if an overlapped portion exists in the conductive pattern on the reflow surface and the conductive pattern on the dip surface by using multiple silver through holes 16 and the like, parasitic capacity 61 occurs, which may become the cause of unstable operation of the circuit, but as shown in FIG. 6 (b), this can be prevented by using the jumper wire 19.

Moreover, when forming the ground line on the reflow surface side and the dip surface side, it becomes possible to stabilize the voltage level (reference voltage level) of the ground line by realizing all the electrical connection between the two layers via jumper wire.

Further, as in the case of the present embodiment in which components are soldered via dip soldering and reflow soldering to a double-sided board, by setting the surface having the bent portion 19c of the jumper wire 19 as the reflow surface, or if both sides of the board are reflow surfaces, by arranging the bent portion 19c on the side subjected to soldering first (or by subjecting the terminal portion 19b to reflow soldering first), the jumper wire 19 can be fixed to the double-sided printed circuit board 1, and there is no need to especially consider the fixing structure of the jumper wire 19 to the substrate, so the operation efficiency is improved.

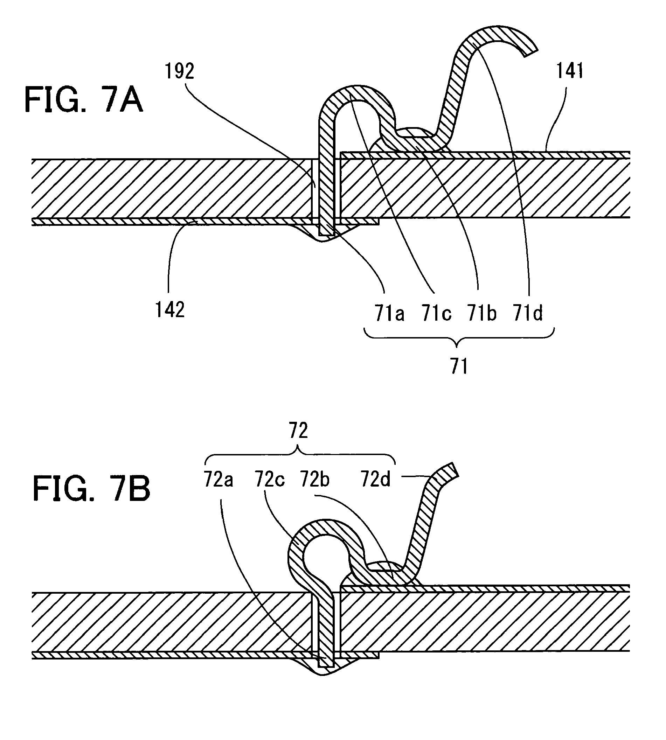

FIG. 7 illustrates another jumper wire. As shown in FIG. 7 (a), a jumper wire 71 inserted to a through hole 192 comprises a terminal portion 71a soldered onto the conductive pattern 142 on the dip surface, a terminal portion 71b substantially orthogonal to the terminal portion 71a and soldered onto the conductive pattern 141 on the reflow surface, an intermediate bent portion 71c, and a contact portion 71d for coming into contact with a chassis ground of the electronic device on which the double-sided printed circuit board including the jumper wire 71 is mounted. The function of the bent portion 71c is similar to the bent portion 19c of the jumper wire 19 (therefore, the shape of the bent portion 71c can be made similar to the jumper wire 19 as shown in FIG. 7(b)).

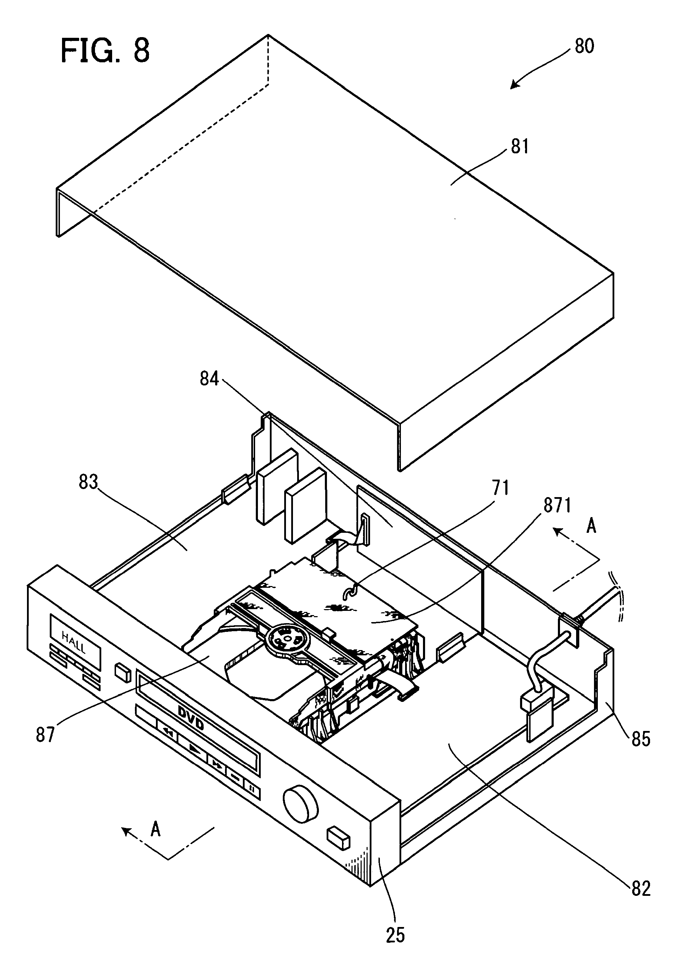

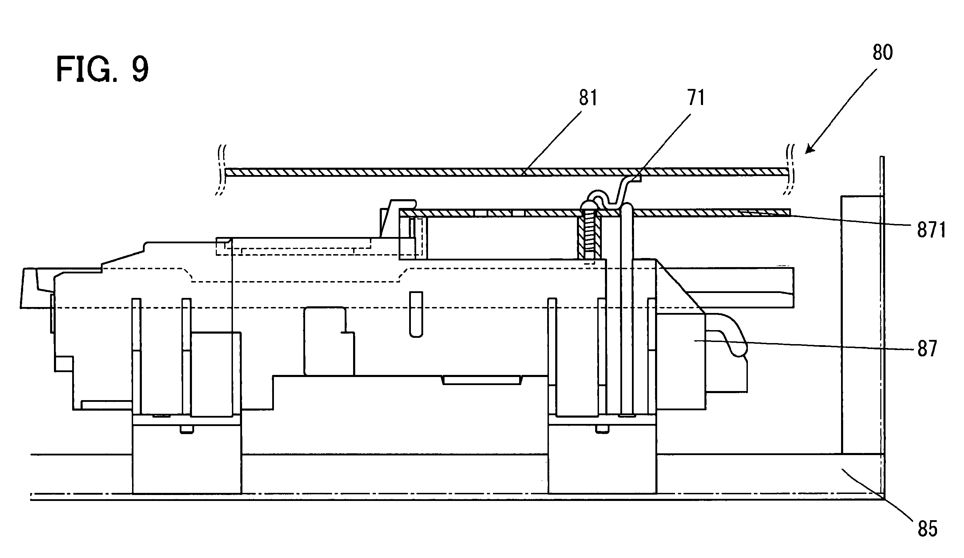

FIG. 8 shows a DVD player 80 as an actual example of the electronic device equipped with the multi-layer printed circuit board with a through hole according to the present invention (illustrating a schematic exploded view showing the state in which a top panel 81 is removed). On the upper portion of a disk device 87 disposed on the DVD player 80 is placed a multi-layer printed circuit board 871 with a through hole (a board on which a jumper wire 71 is provided on the ground line). FIG. 9 is a cross-sectional view taken along line A-A of FIG. 8 (in which the irrelevant portions are simplified and the jumper wire 71 is shown in enlarged view for sake of better understanding). As shown, the DVD player 80 is designed so that the contact portion 71d of the jumper wire 71 (which is the jumper wire disposed on the ground line) disposed on the multi-layer printed circuit board 871 is in contact with the top panel 81 (which is formed of a conductive member, and electrically connected with a chassis 85 also formed of a conductive member).

Since the other boards 82 through 84 mounted on the device are positioned close to the chassis 85 (or screw-engaged to the chassis 85), they can be easily grounded to the chassis, but in the case of the multi-layer printed circuit board 871, it is structurally difficult to achieve ground connection with the chassis 85. However, according to the present multi-layer printed circuit board 871, the contact portion 71d formed on the jumper wire 71 disposed on the ground line is designed to come into contact with the conductive casing (top panel 81), so it can be easily grounded to the chassis without having to provide special structures or members to achieve chassis ground of the printed circuit board, and the voltage level (reference voltage level) of the ground line of the board can be further stabilized.

Moreover, so as not to apply excessive load to the soldered portion, if the bent portion of the jumper wire has sufficient elasticity or if the product has sufficient manufacture accuracy, it is possible to utilize the bent portion 19c of the jumper wire 19 shown in FIG. 3 as the contact portion to be in contact with the conductive casing or frame.

The present embodiment was described using the double-sided board in which components are soldered via dip soldering and reflow soldering as one example of the multi-layer printed circuit board, but the scope of the present invention is not restricted to this example, and the present invention can be applied effectively to other types of multi-layer boards in which the electrical connection of circuits formed on the front side of the board and the rear side of the board is performed via a connection realized by filling conductive paste in the through hole (such as a silver through hole).

The invention further consists in a multi-layer printed circuit board with a through hole comprising circuits formed at least on a front surface and a rear surface of the board, a power supply terminal to which a power supply voltage is entered, an earth terminal connected to a ground level functioning as a reference voltage, a power supply line connected to the power supply terminal, a ground line connected to the earth terminal, connections for electrically connecting circuits formed on the front surface and the rear surface of the board by providing a through hole and a conductor in the through hole, and a load connected to the power supply line and the ground line to receive power supply, the multi-layer printed circuit board having the power supply line and the ground line formed on the front surface and the rear surface thereof respectively according to the required circuit configuration, with the power supply line or the ground line formed on the front surface and the power supply line or the ground line formed on the rear surface electrically connected via said connection; wherein a plurality of said connections being formed by filling the interior of the through hole with conductive paste with respect to a closed circuit that starts from the power supply terminal and passes the power supply line, one or more of said connections, the load and the ground line to reach the earth terminal, if a voltage drop quantity of said one or more connections exceeds a value determined by a predetermined rate with respect to the power supply voltage, all or some of said one or more connections are provided by a jumper wire so that the voltage drop quantity at said one or more connections is equal to or smaller than the value determined by the predetermined rate.

## Claims

1. A multi-layer printed circuit board with a through hole comprising circuits formed at least on a front surface and a rear surface of the board, a power supply terminal to which a power supply voltage is entered, an earth terminal connected to a ground level functioning as a reference voltage, a power supply line connected to the power supply terminal, a ground line connected to the earth terminal, a connection for electrically connecting circuits formed on the front surface and the rear surface of the board by providing a through hole and filling the interior thereof with conductive paste, and a load connected to the power supply line and the ground line to receive power supply, the multi-layer printed circuit board having the power supply line and the ground line formed on the front surface and the rear surface thereof respectively according to the required circuit configuration, with the power supply line or the ground line formed on the front surface and the power supply line or the ground line formed on the rear surface electrically connected via said connection;
**characterized in that**
with respect to a closed circuit that starts from the power supply terminal and passes the power supply line, one or more of said connections, the load and the ground line to reach the earth terminal, if a voltage drop quantity of said one or more connections exceeds a value determined by a predetermined rate with respect to the power supply voltage, all or some of said one or more connections are replaced with a jumper wire so that the voltage drop quantity at said one or more connections is equal to or smaller than the value determined by the predetermined rate.

2. The multi-layer printed circuit board with a through hole according to claim 1, wherein the conductive paste is a silver paste, according to which said connection is a silver through hole, and the predetermined rate is 2 %.

3. The multi-layer printed circuit board with a through hole according to claim 1 or claim 2, wherein all of the connections formed on the ground line are replaced with the jumper wire.

4. The multi-layer printed circuit board with a through hole according to any one of claims 1 through 3, wherein a portion of or all the jumper wires disposed on the ground line comprises a terminal portion to be inserted to the through hole, an intermediate bent portion, and a contact portion coming into contact with a chassis ground of an electronic device on which the multi-layer printed circuit board with a through hole and jumper wire is mounted.

5. An electronic device having the multi-layer printed circuit board with a through hole according to claim 4, further comprising a conductive casing or a conductive frame, wherein the contact portion comes into contact with the casing or the frame.

6. A method for manufacturing a multi-layer printed circuit board with a through hole comprising circuits formed at least on a front surface and a rear surface of the board, a power supply terminal to which a power supply voltage is entered, an earth terminal connected to a ground level functioning as a reference voltage, a power supply line connected to the power supply terminal, a ground line connected to the earth terminal, a connection for electrically connecting circuits formed on the front surface and the rear surface of the board by providing a through hole and filling the interior thereof with conductive paste, and a load connected to the power supply line and the ground line to receive power supply, the multi-layer printed circuit board having the power supply line and the ground line formed on the front surface and the rear surface thereof respectively according to the required circuit configuration, with the power supply line or the ground line formed on the front surface and the power supply line or the ground line formed on the rear surface electrically connected via said connection; the method **characterized in that**
during a design stage, with respect to a closed circuit that starts from the power supply terminal and passes the power supply line, one or more of said connections, the load and the ground line to reach the earth terminal, if a voltage drop quantity of said one or more connections computed based on a current value determined by the power supply specification of the circuit exceeds a value determined by a predetermined rate with respect to the power supply voltage, all or some of said one or more connections are replaced with a jumper wire so that the voltage drop quantity at said one or more connections is equal to or smaller than the value determined by the predetermined rate; or
during an experimental stage, with respect to a closed circuit that starts from the power supply terminal and passes the power supply line, one or more of said connections, the load and the ground line to reach the earth terminal, if a voltage drop quantity of said one or more connections computed based on a measured current value or a voltage drop quantity obtained by measuring a voltage value between terminals of said one or more connections exceeds a value determined by a predetermined rate with respect to the power supply voltage, all or some of said one or more connections are replaced with a jumper wire so that the voltage drop quantity at said one or more connections is equal to or smaller than the value determined by the predetermined rate.

7. The method for manufacturing a multi-layer printed circuit board with a through hole according to claim 6, wherein the conductive paste is a silver paste, according to which said connection is a silver through hole, and the predetermined rate is 2 %.
